# FASCICULE DE BREVET EUROPEEN

(11) **EP 1 569 504 B1**
(45) Date de publication et mention de la délivrance du brevet: **05.05.2010**
(21) Numéro de dépôt: 04292973.7
(22) Date de dépôt: 14.12.2004
(51) Int. Cl.: H05K 3/34, H05K 5/00, H05K 7/14

(54) **Boîtier électrique à connecteur intégré**
Elektrisches Gehäuse mit einem integrierten Verbinder
Electrical housing with integrated connector

(30) Priorité: 18.12.2003 FR 0314950
(43) Date de publication de la demande: 31.08.2005
(73) Titulaire: Johnson Controls Technology Company, Holland, MI 49423 (US)
(72) Inventeur: Combe, Jean-Christophe, 72450 Montfort Le Gesnois (FR); Montarou, Laurent, 75018 Paris (FR)
(74) Mandataire: Bloch, Gérard

(56) Documents cités:
- WO-A-03/079743
- DE-A- 10 162 600
- FR-A- 2 556 550
- US-A- 4 506 443
- US-A1- 2003 201 310

## Description

L'invention concerne les boîtiers électriques et/ou électroniques utilisés notamment dans les véhicules automobiles, à connecteurs intégrés, ou à connectique intégrée, selon l'appellation du métier.

Dans le domaine de l'électronique automobile, les unités de contrôle habitacle ou moteur ont la particularité de devoir protéger une carte à circuit imprimé portant à la fois des composants électroniques, pour sa partie intelligente, et électrique, ou de puissance, pour sa partie assurant les commandes d'actionneurs externes.

Les composants électroniques, qui sont des circuits logiques, sont pratiquement tous des CMS (composants montés en surface), placés directement, à leur position définitive, sur les pistes du circuit imprimé d'une des faces de la carte. En l'occurrence, le circuit imprimé est obtenu par sérigraphie de crème à braser, les CMS y sont placés, et le tout est passé dans un four à DD refusion WW pour les y braser.

Dans les unités de contrôle, la plupart des composants électriques de puissance et les connecteurs sont des composants DD traversants WW, tels que condensateurs, inductances, transistors de puissance, ... , montés sur la face opposée de la carte, et dont les broches, ou les pattes, selon le composant, traversent la carte percée de trous traversants, pour rejoindre les pistes du circuit imprimé sur lesquelles elles doivent être soudées.

Un boîtier à connectique intégrée est un boîtier qui comporte un ou des connecteurs solidaires du boîtier, et non de la carte à circuit imprimé, avant le montage de la carte dans le boîtier. En fait, le boîtier et les connecteurs sont formés d'une seule pièce, généralement en plastique moulé, et les broches y sont surmoulées ou insérées.

La demande DE 101 62 600 A (BOSCH GMBH ROBERT) du 10 Juillet 2003 décrit une carte électronique comprenant un boîtier inférieur et boîtier un boîtier supérieur comportant des connecteurs solidaires du boîtier et des moyens de stabilisation de ladite carte électronique.

Pour la réalisation des unités de contrôle, on a recours à deux technologies de soudage : soudage à la vague et refusion.

Le procédé est le suivant :
1) réalisation des pistes du circuit imprimé,
2) pose des CMS,
3) refusion,
4) pose des composants traversants,
5) pose du boîtier,
6) soudure à la vague,
7) etc...

Ce procédé permet de monter des unités de contrôle avec boîtier à connectique intégrée.

L'inconvénient majeur de ces boîtiers est le nombre d'opérations à exécuter pour les réaliser, chacune source de défauts.

De plus, si on veut implanter des composants CMS du côté de la carte où s'effectue le soudage à la vague, il faut les masquer et donc augmenter les dimensions du boîtier.

On a pu proposer des connecteurs individuels pouvant être montés en refusion sur la carte imprimée. Mais le temps de pose individuelle de ces types de composants, en général une dizaine dans une unité de contrôle automobile, entraîne un surcoût non négligeable.

C'est ainsi que la demanderesse propose, quant à elle, un boîtier électrique à connectique intégrée comportant un capot pour protéger une carte électronique comportant un circuit imprimé et des composants, dont au moins un connecteur intégré au boîtier; le boîtier étant caractérisé par le fait qu'il est agencé pour le soudage des composants en refusion.

La soudure des composants sur la carte s'effectue en un seul passage dans un four de refusion. Ainsi, les composants CMS sont soudés en refusion en même temps que les composants traversants, parmi lesquels le connecteur solidaire du boîtier, ces derniers selon une technique connue sous l'appellation anglo- saxonne : « pin through paste ».

Avantageusement, le capot du boîtier est agencé pour maintenir simultanément la carte et le connecteur en position de soudage en refusion.

On notera qu'après soudage, le capot et le connecteur sont maintenus par la carte alors qu'en position de refusion, la face de la carte sur laquelle sont soudés les composants CMS étant tournée vers le haut, la carte est maintenue par le capot, tandis que le capot maintient le connecteur en position par rapport à la carte. Notamment, les broches sont maintenues suffisamment traversantes pour déboucher hors des pistes et pouvoir être soudées par refusion.

Le temps de pose des composants, confondu avec celui du boîtier, reste le même quel que soit le nombre de connecteurs à souder sur la carte.

De préférence, le capot maintient le connecteur par des bras flexibles, la liaison entre ce dernier et le boîtier restant souple.

Quand la refusion est terminée, le connecteur est solidaire de la carte par ses broches et c'est le capot qui flotte par rapport au connecteur, donc par rapport à la carte, où l'inverse, suivant le mode de maintien du boîtier pendant la refusion, de sorte que les contraintes thermiques sont sans danger pour la fiabilité des soudures des contacts électriques.

De préférence encore, le capot et le connecteur sont en matière plastique.

De préférence toujours, le capot comporte des pattes de retenue des composants traversants.

Avantageusement, le capot et la carte sont maintenus assemblés par des clips et des ergots.

Le procédé d'assemblage du boîtier précédent peut alors comporter les étapes suivantes :
1) sérigraphie en crème à braser des plages du circuit imprimé,
2) pose des composants traversants,
3) pose du boîtier,
4) pose des composants CMS,
5) passage au four à refusion.

L'invention sera mieux comprise à l'aide de la description suivante du boîtier selon l'invention et du dessin annexé sur lequel :
- la figure 1 est un schéma en coupe du boîtier et de la carte assemblés en position de refusion, selon l'invention ;
- la figure 2 représente un organigramme du déroulement des étapes de montage de la carte électronique dans le boîtier.

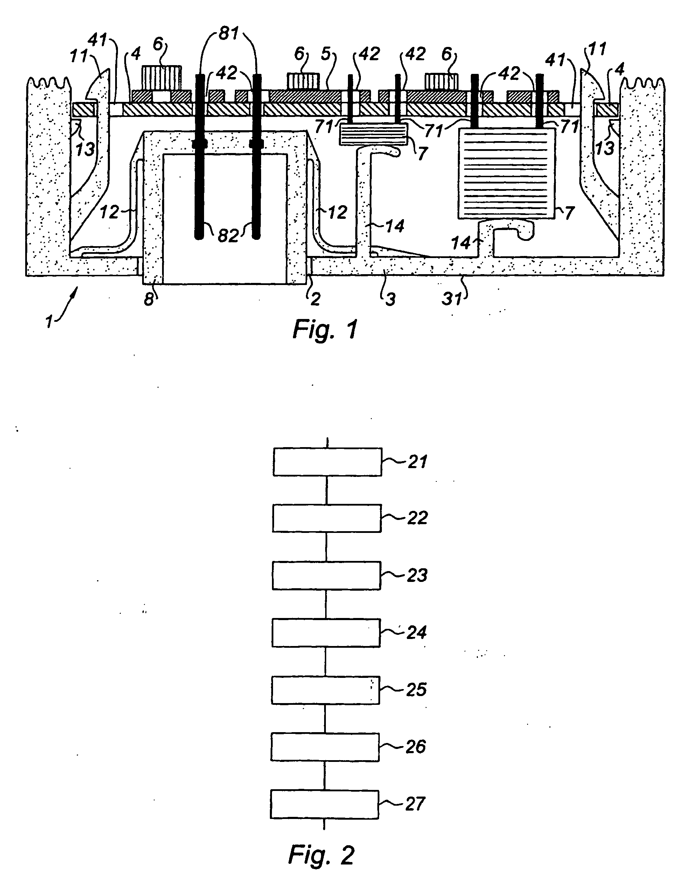

En référence à la figure 1, un boîtier électrique 1 comporte une carte 4 équipée et un capot 3.

La carte 4, sur laquelle un circuit 5 a été imprimé, comporte des ouvertures 41, pour laisser passer des clips 11 de retenue du capot 3, et des trous traversants 42, traversant également les pistes du circuit imprimé 5, pour laisser passer soit des pattes 71 de composants traversants 7 soit des queues à souder 81 d'un connecteur 8 intégré au capot, les queues 81 faisant corps avec les contact électriques 82 du connecteur. Naturellement, au boîtier pourraient être intégrés d'autres connecteurs, comme ce sera souvent le cas.

Des composants montés en surface (CMS) 6 sont brasés sur des pistes 5 de la carte 4.

Sur la figure 1, le boîtier 1 est présenté en position de brasage des composants CMS, et sa surface inférieure 31, c'est-à-dire celle du capot 3, repose par gravité sur le plan de pose d'un four à refusion non représenté.

Dans cette position, avant le brasage, ni les composants traversants 7 ou le connecteur 8 dont les queues à souder 81 ou pattes 71 sont libres dans les trous 42, ni le capot 3, dont les clips 11 sont libres dans les ouvertures 41, ne sont fixés à la carte 4.

Aussi, pour maintenir la carte en position correcte par rapport au plan de pose 31, des ergots 13 ont été prévus sur les faces latérales internes du capot 3 et en cours de brasage la carte repose sur ces ergots 13.

De même, pour maintenir correctement les composants traversants 7 pendant le brasage, des pattes de retenue, ou de maintien, 14 ont été prévues intégrées dans le fond du capot. Ces pattes de retenue peuvent d'ailleurs être montées sur des lamelles libres en flexion. Ainsi, les composants sont encore mieux plaqués contre la carte, même si leurs dimensions sont aux limites des tolérances.

Le connecteur 8, intégré au capot, n'a pas besoin d'être maintenu de cette façon. Cependant, pour éviter, après le brasage, toute contrainte mécanique ultérieure sur les soudures entre les queues à souder 81 et les pistes du circuit 5, le connecteur 8 est solidaire du capot 3 par des bras flexibles 12 lui permettant de rester flottant par rapport au capot.

Enfin, le connecteur 8 est accessible à travers la face inférieure 31 du capot 3 par une ouverture 2 ménagée dans cette face 31 laissant le connecteur jouer librement par rapport à celle-ci.

Ainsi, la carte 4, en position de refusion, est maintenue par le capot 3, et le capot 3 maintient le connecteur 8 en position par rapport à la carte 4, notamment les queues à souder 81 sont maintenues suffisamment traversantes pour déboucher hors des pistes du circuit 5 et pour pouvoir être soudées par refusion en même temps que les composants CMS 6.

On voit que c'est le capot 3 qui maintient simultanément la carte 4 et le connecteur 8 en position de soudage par refusion.

On voit de plus que, après soudage, c'est la carte 4 qui maintient simultanément le capot 3, par les clips 11 et les ergots 13, et le connecteur 8, par ses broches, en position d'utilisation, le capot 3 étant flottant par rapport au connecteur 8 grâce aux bras flexibles 12.

On remarquera que les bras flexibles 12, les clips 11 et les ergots 13 peuvent être venus de matière avec le capot 3.

Il est alors possible d'assembler le boîtier, en référence à la figure 2, par les étapes successives suivantes :
1) sérigraphie, en crème à braser (étape 21),
2) retournement (étape 22),
3) pose des composants traversants (étape 23),
4) pose du boîtier (étape 24),
5) retournement (étape 25),
6) pose des composants CMS (étape 26),
7) passage au four à refusion (étape 27).

Pour appliquer ce procédé, il importe que le capot 3 et le connecteur 8 soient en matière plastique supportant les températures atteintes lors de l'opération de refusion.

Comme il a déjà été sous-entendu plus haut, dans une autre forme de réalisation de l'invention, la carte, le boîtier et le capot sont agencés pour que ce soit la carte qui maintienne le boîtier et le connecteur pendant l'opération de refusion.

## Revendications

1. Boîtier électrique (1) comportant un capot (3) pour protéger une carte électronique (4) comportant un circuit imprimé (5) et des composants (6, 7, 8), dont au moins un connecteur (8) intégré au boîtier (1), le boîtier étant **caractérisé par le fait que** le capot (3) comporte des pattes (14) de retenue des composants traversants (7) agencées pour plaquer lesdits composants traversants (7) contre la carte électronique (4) pour permettre le soudage des composants (6, 7, 8) par refusion.

2. Boîtier selon la revendication 1, dans lequel, après le soudage, le capot (3) et le connecteur (8) sont maintenus par la carte (4).

3. Boîtier selon l'une des revendications 1 et 2, dans lequel, pendant le soudage, la carte (4) est maintenue par le capot (3).

4. Boîtier selon l'une des revendications 1 à 3, dans lequel le connecteur (8) est solidaire du capot (3) par des bras flexibles (12).

5. Boîtier selon l'une des revendications 1 à 4, dans lequel le capot (3) et la carte (4) sont maintenus assemblés par des clips (11) et des ergots (13).

6. Boîtier selon l'une des revendications 1 à 5, dans lequel le capot (3) et le connecteur (8) sont en matière plastique supportant les températures atteintes lors de l'opération de refusion.

7. Boîtier selon la revendication 4 et l'une des revendications 5 et 6, dans lequel les bras flexibles (12), les clips (11) et les ergots sont venus de matière avec le capot (3).

## Claims

1. Electrical package (1) including a cover (3) for protecting an electronic board (4) including a printed circuit (5) and components (6, 7, 8), at least one of which is a connector (8) integral with the package (1), which package is **characterised in that** the cover (3) includes pads (14) for retaining going through components (7) arranged to press said going through components (7) onto the electronic board (4) to enable the components (6, 7, 8) to be reflow welded.

2. Package according to claim 1, wherein, after welding, the cover (3) and the connector (8) are maintained by the board (4).

3. Package according to any of claims 1 and 2, wherein, during welding, the board (4) is maintained by the cover (3).

4. Package according to one of claims 1 to 3, wherein the connector (8) is integral with the cover (3) through flexible arms (12).

5. Package according to one of claims 1 to 4, wherein the cover (3) and the board (4) are maintained together by clips (11) and lugs (13).

6. Package according to one of claims 1 to 5, wherein the cover (3) and the connector (8) are of plastics material withstanding the temperatures experienced during the reflow operation.

7. Package according to claim 4 and any of claims 5 and 6, wherein the flexible arms (12), clips (11) and lugs are of a material coming from the cover (3).

## Patentansprüche

1. Elektrisches Gehäuse (1), umfassend eine Abdeckung (3) zum Schutz einer elektronischen Platte (4), die eine gedruckte Schaltung (5) und Bauteile (6, 7, 8) umfasst, von denen mindestens ein Steckverbinder (8) in das Gehäuse (1) integriert ist, wobei das Gehäuse **dadurch gekennzeichnet ist, dass** die Abdeckung (3) Laschen (14) zum Festhalten der durchgehenden Bauteile (7) umfasst, die angeordnet sind, um die durchgehenden Bauteile (7) an die elektronische Platte (4) zu drücken, um das Verschweißen der Bauteile (6, 7, 8) durch Aufschmelzen zu ermöglichen.

2. Gehäuse nach Anspruch 1, wobei nach dem Verschweißen die Abdeckung (3) und der Steckverbinder (8) von der Platte (4) gehalten werden.

3. Gehäuse nach einem der Ansprüche 1 und 2, wobei während des Verschweißens die Platte (4) von der Abdeckung (3) gehalten wird.

4. Gehäuse nach einem der Ansprüche 1 bis 3, wobei der Steckverbinder (8) über biegsame Arme (12) mit der Abdeckung (3) fest verbunden ist.

5. Gehäuse nach einem der Ansprüche 1 bis 4, wobei die Abdeckung (3) und die Platte (4) durch Klammern (11) und Vorsprünge (13) zusammengehalten werden.

6. Gehäuse nach einem der Ansprüche 1 bis 5, wobei die Abdeckung (3) und der Steckverbinder (8) aus Kunststoff bestehen, der die Temperaturen aushalten kann, die während des Aufschmelzvorgangs erreicht werden.

7. Gehäuse nach Anspruch 4 und einem der Ansprüche 5 und 6, wobei die biegsamen Arme (12), die Klammern (11) und die Vorsprünge aus demselben Material einstückig geformt sind wie die Abdeckung (3).
